# EUROPÄISCHE PATENTSCHRIFT

(11) **EP 2 630 994 B1**
(45) Veröffentlichungstag und Bekanntmachung des Hinweises auf die Patenterteilung: **30.05.2018**
(21) Anmeldenummer: 12198265.6
(22) Anmeldetag: 19.12.2012
(51) Int. Cl.: A62C 3/16, A62C 35/10, A62C 37/14, H01H 37/76, H01H 37/36

(54) **Elektrisches Kleingerät mit Brandschutzeinrichtung**
Small electrical device with a fire protection device
Petits appareils électriques avec un dispositif de protection anti-incendie

(30) Priorität: 24.02.2012 DE 202012100623 U
(43) Veröffentlichungstag der Anmeldung: 28.08.2013
(60) Teilanmeldung: 18158230.5
(73) Patentinhaber: Job Lizenz GmbH & Co. KG, 22926 Ahrensburg (DE)
(72) Erfinder: Klug, Rüdiger, 22926 Ahrensburg (DE); Müller, Bodo, 25436 Tornesch (DE); Teschner, Jürgen, 22339 Hamburg (DE)
(74) Vertreter: Raffay & Fleck

(56) Entgegenhaltungen:
- EP-A1- 0 094 192
- EP-A1- 2 541 666
- EP-B1- 0 838 242
- WO-A1-02/40101
- WO-A1-88/06046
- WO-A1-97/26945
- DE-A1- 3 340 652
- DE-U1-202011 050 661

## Beschreibung

Die Erfindung betrifft ein mit einem Gehäuse versehenes elektrisches Kleingerät mit einer darin angeordneten Brandschutzeinrichtung. Sie betrifft ferner die Verwendung eines Berstgefäßes in Form eines mit einer Auslöseflüssigkeit gefüllten Glasfässchens als Brandschutzeinrichtung für elektrische Kleingeräte.

Aus der EP 0 094 192 A1 ist eine Brandschutzeinrichtung bekannt, die auch zur Anordnung in elektrischen Kleingeräten vorgesehen ist. Diese besteht aus einem spiralförmigen Kunststoffrohr, dass allseits verschlossen und mit einer unter Druck stehenden Löschflüssigkeit gefüllt ist. Im Brandfalle erwärmt die Kunststoffwand, reißt lokal dort, wo der höchste Wärmeeintrag stattfindet, auf und entlässt durch den gebildeten Riss die Löschflüssigkeit an dieser Stelle.

Flüssigkeitsgefüllte Glasfässchen sind z.B. aus der WO 02/40101 A1 als thermische Auslöser für Sprinkleranlagen bekannt.

Elektrische Kleingeräte im Sinne dieser Erfindung sind mit elektrischem Strom betriebene Geräte geringer Abmessungen, wobei unter geringen Abmessungen Kantenlängen von maximal 1 m, typischerweise im Bereich von einigen cm bis einigen dm zu verstehen sind. Ein typisches elektrisches Kleingerät beispielsweise ist ein Netzteil, wie es heutzutage vielfach z.B. im Zusammenhang mit Laptops verwendet wird. Derartige Netzteile haben z.B. Abmessungen von 10 bis 15 cm entlang ihrer längsten Kantenlänge und bis zu 10 cm entlang der kürzeren Kantenlängen. Sie bergen gekapselt in einem Gehäuse elektrische Komponenten zur Spannungswandlung einer Versorgungsspannung ausgehend von der Netzspannung, in Europa beispielsweise 230 V Wechselspannung, zu einer Versorgungsspannung für das zu versorgende elektrische Gerät, beispielsweise einen Laptop, z.B. eine Gleichspannung von 12 V.

Derartige elektrische Kleingeräte, wie beispielsweise solche Netzteile, erhitzen im Betrieb. Liegt ein Schaden vor, so kann beispielsweise durch einen Kurzschluss oder durch eine nicht durch ein entsprechendes Sicherungsmittel abgefangene Überlast eine Überhitzung eines solchen elektrischen Kleingerätes, beispielsweise eines Netzteils, auftreten, die ungünstigenfalls zu einer Entzündung von in dem elektrischen Kleingerät vorhandenen Kunststoffkomponenten und damit zur Auslösung eines Brandes führt. Diverse Wohnungs- und Hausbrände oder Brände in Bürogebäuden sind auf defekte elektrische Kleingeräte zurückzuführen, die sich aufgrund einer derartigen Fehlfunktion entzündet und damit den Brand ausgelöst haben.

Zwar sind elektrische Kleingeräte häufig mit elektrischen Sicherungen versehen, die bei einem Defekt und einem daraufhin auftretenden Überstrom auslösen und die weitere Stromversorgung kappen sollen, jedoch sind derartige Sicherungen nicht immer ausreichender Schutz vor einem Brand eines solchen elektrischen Kleingerätes. Insbesondere können derartige Sicherungen dann nicht mehr effektiven Schutz bieten, wenn bereits vor Auslösen der Sicherung eine zu starke Überhitzung des elektrischen Kleingerätes bzw. der daran angeordneten elektrischen Komponenten stattgefunden hat.

Hier soll mit der Erfindung Abhilfe geschaffen werden, indem ein elektrisches Kleingerät mit einer zuverlässigen Brandschutzeinrichtung angegeben wird.

Erfindungsgemäß wird in einem elektrischen Kleingerät eine Brandschutzeinrichtung in Form eines einen vollständig umschlossenen und von einer Gefäßwand begrenzten Hohlraum aufweisenden Glasfässchens als Berstgefäß, wobei in dem Hohlraum eine Flüssigkeit angeordnet ist, die zwei wesentlichen Eigenschaften aufweist. Diese Flüssigkeit lässt nämlich aufgrund thermischer Ausdehnung bei einer vorbestimmten Auslösetemperatur die Gefäßwand brechen und das Glasfässchen bersten. Darüber hinaus hat die Flüssigkeit eine Brand verhindernde Wirkung und/oder eine Löschwirkung.

Somit wirkt die in dem erfindungsgemäßen elektrischen Kleingerät vorgesehene Brandschutzeinrichtung wie folgt: Durch die vorbestimmte Auslösetemperatur wird mit der Brandschutzeinrichtung ein Übersteigen einer maximal zulässigen Temperatur, nämlich der Auslösetemperatur überwacht und bei einer Überhitzung des elektrischen Kleingerätes, also einem Übersteigen der Innentemperatur in dem Gehäuse, in dem die Brandschutzeinrichtung eingeordnet wird, jenseits der Auslösetemperatur ein Auslösen, nämlich Bersten des Glasfässchens, herbeigeführt. Sodann sorgt die aus dem Glasfässchen austretende Flüssigkeit für eine Brand verhindernde Wirkung bzw. eine Löschwirkung. Auf diese Weise können ggf. bei der Auslösetemperatur bereits aufgetretene Schwelbrände im Inneren des elektrischen Kleingerätes gelöscht werden, bzw. es kann bei drohender Gefahr eines solchen Schwelbrandes dieser aufgrund der Brand verhindernden Wirkung der Flüssigkeit verhindert werden.

Berstgefäße, wie sie erfindungsgemäß für die Brandschutzeinrichtung Verwendung finden, sind demnach sogenannte Glasfässchen bzw. beidseitig verschlossene Glasröhrchenabschnitte, wie sie z.B. für Auslöseventile von Sprinkleranlagen Verwendung finden. Dort werden entsprechende Glasfässchen zwischen ein Widerlager und einen Verschlussteller einer Sprinkleranlage eingesetzt. Sie sind mit einer Auslöseflüssigkeit, die bei einem Überschreiten einer Auslösetemperatur aufgrund der thermischen Ausdehnung das Glasfässchen zum Platzen bringen, gefüllt, wobei bei einem Bersten bzw. Platzen des Glassfässchens der Ventilteller der Sprinkleranlage freigegeben und mithin das Sprinklerventil geöffnet wird. In dieser Anwendung besteht die Funktion der Flüssigkeit allein in der thermischen Auslösung, entsprechend wird die Flüssigkeit ausgewählt. Eine Brand verhindernde Wirkung und/oder eine Löschwirkung ist für die Auslöseflüssigkeit belanglos, eine solche Wirkung weisen bekannte Auslöseflüssigkeiten nicht auf.

Mit Vorteil ist bei der in dem erfindungsgemäßen elektrischen Kleingerät angeordneten Brandschutzeinrichtung in dem Hohlraum zusätzlich zu der Flüssigkeit eine Gasblase angeordnet. Diese Gasblase kann beispielsweise einer Luftblase, kann aber auch eine Blase aus einem nicht Brand befördernden Gas, beispielsweise Stickstoff oder Kohlendioxid, sein. Eine solche Gasblase kann für die exakte Einstellung der Auslösetemperatur des Berstgefäßes dienen.

Gemäß einer weiteren vorteilhaften Weiterbildung der Erfindung weist die Flüssigkeit einen Siedepunkt bei einer Temperatur unterhalb der Auslösetemperatur auf. Dies führt dazu, dass nach einem Bersten des Glasfässchens die frei werdende Flüssigkeit unmittelbar verdampft bzw. in die Gasphase übergeht. Durch die starke Ausdehnung eines Stoffes beim Übergang in die Gasphase (bei einem idealen Gas nimmt ein Mol eines solchen Gases bei Normbedingungen ein Volumen von etwa 22,4 Liter ein) erfüllt das aus der Flüssigkeit gebildete Gas mit hoher Geschwindigkeit den Innenraum des Gehäuses des elektrischen Kleingerätes und kann seine Brand verhindernde Wirkung und/oder Löschwirkung ausüben. Diese Löschwirkung bzw. Brand verhindernde Wirkung kann in der Verdrängung von für jegliche Form eines Brandes erforderlichen Sauerstoffes aus dem Gehäuse des elektrischen Kleingerätes heraus gebildet sein. Sie kann aber auch in einer Wirkung durch homogene Inhibition liegen.

Eine andere Form der Löschwirkung, bei der es nicht erforderlich ist, eine Flüssigkeit zu wählen, deren Siedepunkt bei einer Temperatur unterhalb der Auslösetemperatur liegt, kann z.B. darin bestehen, dass die Flüssigkeit, wenn Sie einmal freigesetzt ist, eine Schaumbildung erfährt und darüber die Löschwirkung entfaltet. Eine solche Schaumbildung kann z.B. durch eine Reaktion mit Bestandteilen der in dem elektrischen Kleingerät vorhandenen Atmosphäre geschehen, oder aber auch durch das Zusammentreffen zweiter Flüssigkeitskomponenten, wenn diese z.B. in dem Berstgefäß getrennt enthalten sind und erst nach dem Bersten zusammengeführt sind.

Eine weitere mögliche Löschwirkung kann sich ergeben, wenn die Flüssigkeit eine hohe Bindungsaffinität zu Sauerstoff hat und so bereits als tröpfchenförmig verteilte Flüssigkeit in dem Innenraum des elektrischen Kleingerätes den dort enthaltenen Sauerstoff, insbesondere chemisch, bindet und so dem Brandherd entzieht. Auch dann kann die Flüssigkeit ohne ein Verdampfen die Löschwirkung entfalten und muss nicht mit einem unterhalb der Auslösetemperatur liegenden Siedepunkt gewählt werden.

Geeignete Flüssigkeiten für den Zweck der in dem erfindungsgemäßen elektrischen Kleingerät angeordneten Brandschutzeinrichtung sind beispielsweise Halone. Weiterhin können fluorierte Ketone verwendet werden, insbesondere ein perfluoriertes Ethyl-Isopropylketon.

Eine zusätzliche Schutzfunktion ergibt sich für die in dem erfindungsgemäßen elektrischen Kleingerät angeordnete Brandschutzeinrichtung, wenn zugleich ein zwischen zwei auf dem Berstgefäß ausgebildeten Kontaktpunkten geführter elektrischer Leiter vorgesehen ist, der so ausgebildet ist, dass er beim Bersten des Berstgefäßes zerstört wird. Ein solcher Leiter kann dann insbesondere in dem elektrischen Kleingerät verschaltet werden, um die Spannungsversorgung zu führen. Somit bildet dieser Leiter dann ein eigenes Sicherungselement, da im Falle des Auslösens des Berstgefäßes der elektrische Leiter zerstört und die Spannungsversorgung des elektrischen Kleingerätes gekappt wird. Somit wird neben der Brand verhindernden Wirkung bzw. Löschwirkung der beim Auslösen bzw. Bersten des Berstgefäßes frei werdenden Flüssigkeit dafür Sorge getragen, dass nicht mehr weitere elektrische Energie dem elektrischen Kleingerät zugeführt wird und mithin keine weitere durch diese elektrische Energie bzw. eine Fehlfunktion des elektrischen Kleingerätes bedingte Erwärmung und damit Erhöhung der Brandgefahr auftritt. Dabei kann der elektrische Leiter auch so ausgelegt sein, dass er unabhängig von einem Auslösen der Brandschutzeinrichtung (einem Bersten des Berstgefäßes) als elektrische Überstromsicherung dient. Dazu kann dieser Leiter bspw. ausgelegt sein, bei einem eine vorbestimmte Obergrenze übersteigenden Strom zu schmelzen oder in anderer Weise zerstört zu werden und so die Stromzufuhr zu unterbrechen, selbst wenn das Berstgefäß noch unversehrt ist.

Ein weiterer Aspekt der Erfindung betrifft die Verwendung eines Berstgefäßes in Form eines Glasfässchens mit den oben bereits beschriebenen verschiedenen möglichen Eigenschaften als Brandschutzeinrichtung für ein elektrisches Kleingerät durch Anordnung in einem Gehäuse eines solchen elektrischen Kleingerätes.

Weitere Vorteile und Merkmale der Erfindung ergeben sich aus der nachfolgenden Beschreibung möglicher Ausführungsbeispiele anhand der beigefügten Figuren. Dabei zeigen:
- Fig. 1: eine schematische Ansicht einer möglichen Brandschutzeinrichtung zur Anordnung in einem elektrischen Kleingerät gemäß der Erfindung;
- Fig. 2: eine der Fig. 1 vergleichbare Ansicht einer in einem erfindungsgemäßen elektrischen Kleingerät anzuordnenden Brandschutzeinrichtung in einer alternativen Ausgestaltung;
- Fig. 3: eine der Fig. 1 vergleichbare Ansicht einer in einem erfindungsgemäßen elektrischen Kleingerät anzuordnenden Brandschutzeinrichtung in einer weiteren möglichen Ausgestaltung;
- Fig. 4: eine schematische Darstellung eines mit eines erfindungsgemäß mit einer Brandschutzeinrichtung ausgestatteten elektrischen Kleingerätes, hier eines Netzteils; und
- Fig. 5: eine alternative Ausgestaltung eines erfindungsgemäß mit einer Brandschutzeinrichtung ausgestatteten elektrischen Kleingerätes, auch hier wieder eines Netzteils.

In den Figuren sind mögliche Ausführungsbeispiele der Erfindung in schematischer Darstellung gezeigt. Die Figuren sind dabei keinesfalls maßstabsgerecht und zeigen auch nicht sämtliche Details; es handelt sich vielmehr um Prinzipdarstellungen zur Verdeutlichung der erfindungswesentlichen Merkmale in Zusammenschau mit der nachstehenden Beschreibung dieser Ausführungsbeispiele.

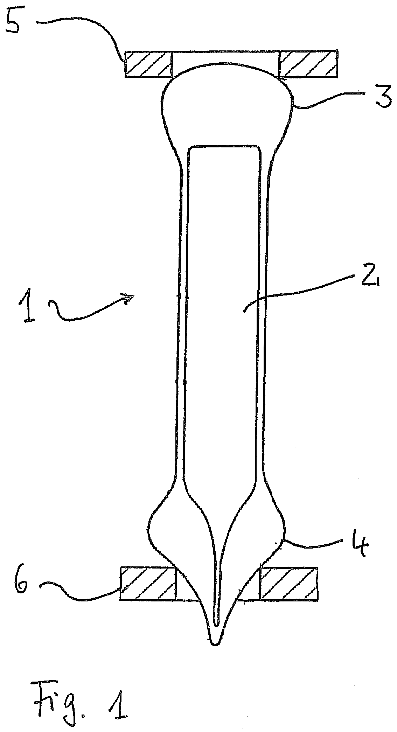

In Fig. 1 ist schematisch ein Berstgefäß 1 gezeigt, welches wesentlicher Bestandteil einer in einem erfindungsgemäßen elektrischen Kleingerät anzuordnenden Brandschutzeinrichtung ist. Dieses Berstgefäß 1, welches hier ein aus einem Glasröhrchen gebildetes, sogenanntes Glasfässchen ist, weist in seinem Inneren einen vollständig durch die Gefäßwand umschlossenen Hohlraum 2 auf. Das Berstgefäß 1 ist dabei im Wesentlichen zylinderförmig mit zwei verdickten Enden 3, 4. An den Enden 3, 4 ist das Berstgefäß 1 zwischen zwei Widerlagern 5, 6 angeordnet und wird so gehalten. In dem Hohlraum 2 ist (hier nicht näher dargestellt) eine Flüssigkeit angeordnet, die das Volumen des Hohlraumes 2 unter Einschluss einer kleinen Gasblase nahezu vollständig füllt. Diese Flüssigkeit ist einerseits so gewählt, dass sie aufgrund thermischer Ausdehnung bei einer vorbestimmten Auslösetemperatur, beispielsweise 50°C, 60°C, 65°C, 70°C oder 90°C, das Berstgefäß 1 zum Bersten bringt und dass sie andererseits eine einen Brand verhindernde Wirkung und/oder eine Löschwirkung aufweist. So wird, wenn die Auslösetemperatur erreicht bzw. überschritten ist, durch Bersten des Berstgefäßes die darin befindliche Flüssigkeit freigesetzt und kann im Inneren des Gehäuses eines elektrischen Kleingerätes die erwünschte Brand verhindernde Wirkung bzw. Löschwirkung erzielen.

Dabei ist die Flüssigkeit hier in vorteilhafter Weise so gewählt, dass sie einen Siedepunkt bei einer Temperatur unterhalb der Auslösetemperatur aufweist, beim Austreten nach Erreichen bzw. Überschreiten der Auslösetemperatur mit anderen Worten schlagartig in die Gasphase übergeht und somit ein deutlich größeres Volumen einnimmt als das Volumen des Hohlraumes 2. So kann mit einer vergleichsweise geringen Menge an Flüssigkeit ein vergleichsweise großes Volumen innerhalb eines Gehäuses eines elektrischen Kleingerätes mit dem entsprechenden Gas, welches aus der Flüssigkeit hervorgeht, befüllt und somit dort die Brand verhindernde Wirkung bzw. die Löschwirkung erzielt werden.

Als mögliche Flüssigkeit in dem Hohlraum 2 kommt ein Halon in Betracht. Gut geeignet ist aber auch ein fluoriertes Keton, wobei in diesem Ausführungsbeispiel ein perfluoriertes Ethyl-Isopropylketon gemäß nachstehender Strukturformel 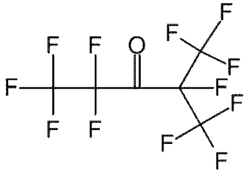 bevorzugt ist.

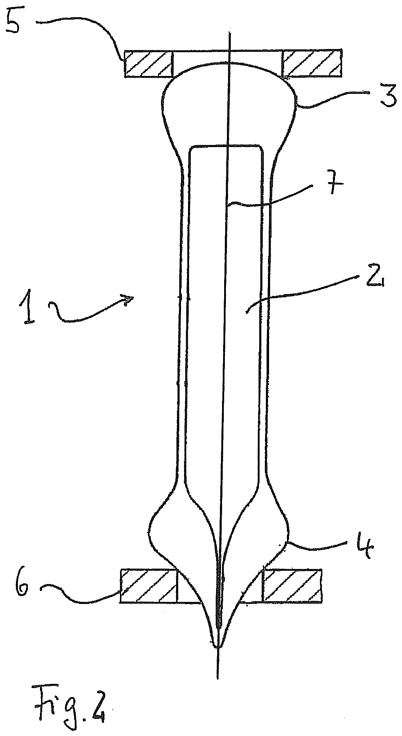

In Fig. 2 ist eine alternative Ausgestaltung eines solchen als Brandschutzeinrichtung in einem erfindungsgemäßen elektrischen Kleingerät anzuordnenden Berstgefäßes 1 gezeigt. Es ist in den wesentlichen Komponenten gleich aufgebaut wie das Berstgefäß 1 aus Fig. 1, enthält lediglich zusätzlich einen entlang der Längsachse des Berstgefäßes 1 geführten, durch den Hohlraum 2 verlaufenden und an den jeweiligen Enden 3 bzw. 4 austretenden elektrischen Leiter 7. Dieser elektrische Leiter kann bei der Verwendung dieses Berstgefäßes als Brandschutzeinrichtung genutzt werden, um über diesen beispielsweise eine Versorgungsspannung für das elektrische Kleingerät zu leiten. Dabei ist die Materialstärke des elektrischen Leiters 7 so gewählt, dass bei einem Bersten des Berstgefäßes 1 aufgrund eines Überschreitens der Auslösetemperatur der elektrische Leiter 7 reißt, also zerstört wird. Dadurch wird erzielt, dass im Falle eines Auslösens nicht nur die Brand verhindernde Wirkung bzw. Löschwirkung der in dem Hohlraum 2 befindlichen Flüssigkeit ausgelöst bzw. erzielt wird, sondern dass zugleich auch eine Unterbrechung der Spannungsversorgung des elektrischen Gerätes erfolgt. Im Übrigen ist der Aufbau des in Fig. 2 gezeigten Berstgefäßes wie derjenige des zu Fig. 1 beschriebenen, auch die Funktion ist gleichartig.

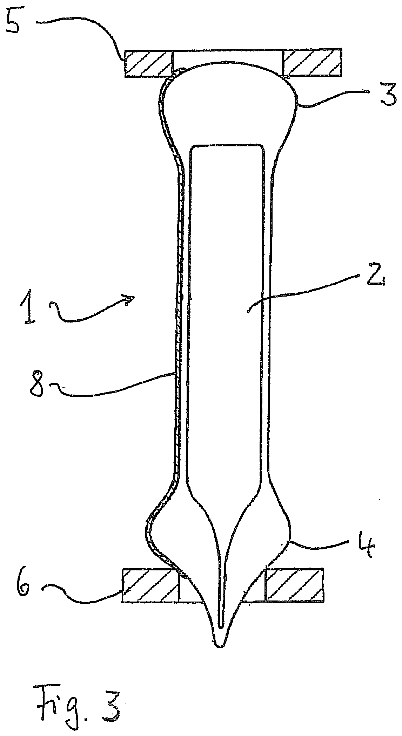

In Fig. 3 ist eine weitere Alternative eines in einem erfindungsgemäßen elektrischen Kleingerät als Brandschutzeinrichtung zu installierenden Berstgefäßes 1 gezeigt, welches wiederum grundsätzlich so aufgebaut ist und derart arbeitet, wie in Fig. 1 beschrieben. Abweichend von dem in Fig. 1 dargestellten Ausführungsbeispiel ist bei dem Berstgefäß 1 gemäß Fig. 3 auf einem Abschnitt der Außenseite des Berstgefäßes eine elektrisch leitende Beschichtung 8 aufgebracht, die sich vom einen Ende 3 des Berstgefäßes 1 zu dessen anderen Ende 4 erstreckt. Diese elektrisch leitende Beschichtung 8 kann beispielsweise über die Widerlager 5 und 6, die die Beschichtung 8 wie gezeigt berühren, kontaktiert werden und damit einen elektrischen Leiter ausbilden, der sich entlang der Längsrichtung des Berstgefäßes 1 erstreckt und über den z.B. eine elektrische Versorgung des elektrischen Kleingerätes geführt werden kann. Auch hier führt dann das Bersten des Berstgefäßes 1 aufgrund des durch seine thermische Ausdehnung oberhalb der Auslösetemperatur ausgeübten Druckes der in dem Hohlraum 2 befindlichen Flüssigkeit, dem die Wand des Berstgefäßes 1 ab der Auslösetemperatur nicht mehr standhalten kann, zu einem Bruch des durch die elektrisch leitende Beschichtung 8 hergestellten Leiters und damit zu einer Unterbrechung der Strom- bzw. Spannungsversorgung des mit dieser Brandschutzeinrichtung ausgestatteten elektrischen Kleingerätes. Im Übrigen ist auch das in Fig. 3 gezeigte Ausführungsbeispiel in Aufbau und Funktion identisch wie dasjenige in Fig. 1, so dass erneut auf die Beschreibung dieser Figur Bezug genommen werden kann.

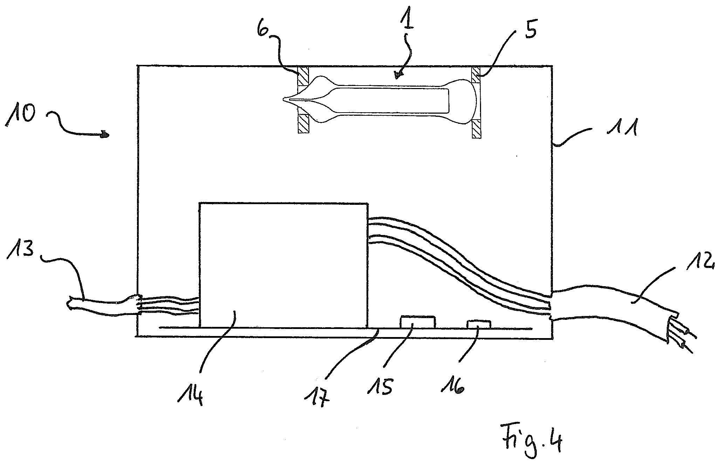

In Fig. 4 ist als Beispiel für ein elektrisches Kleingerät gemäß der Erfindung ein Netzteil 10 schematisch dargestellt. Das Netzteil 10 weist ein Gehäuse 11 auf, in dem die verschiedenen Komponenten angeordnet sind. In das Gehäuse hinein führt ein Netzkabel 12 zum Anschluss an die Netzspannungsversorgung. Aus dem Gehäuse tritt ein Gerätekabel 13 aus, welches zur spannungsangepassten Versorgung eines Verbrauchers dient. Innerhalb des Gehäuses 11 sind ein Spannungswandler 14 und weitere elektrische Komponenten 15, 16 auf einer Platine 17 angeordnet. Der Spannungswandler 14 ist mit dem Netzkabel 12 mit beiden Adern eingangsseitig verbunden, ausgangsseitig speist der Spannungswandler 14 das Gerätekabel 13. Innerhalb des Gehäuses 11 ist zwischen den Widerlagern 5 und 6 ein Berstgefäß 1 gemäß Fig. 1 als Brandschutzeinrichtung angeordnet. Kommt es in dem Netzteil 10 nun zu einer Überhitzung aufgrund einer Fehlfunktion, die über die Auslösetemperatur des Berstgefäßes 1 hinaus geht, führt die in dem Hohlraum des Berstgefäßes 1 angeordnete Flüssigkeit zu einem Bersten des Berstgefäßes und entwickelt sodann ihre Brand verhindernde Wirkung bzw. Löschwirkung.

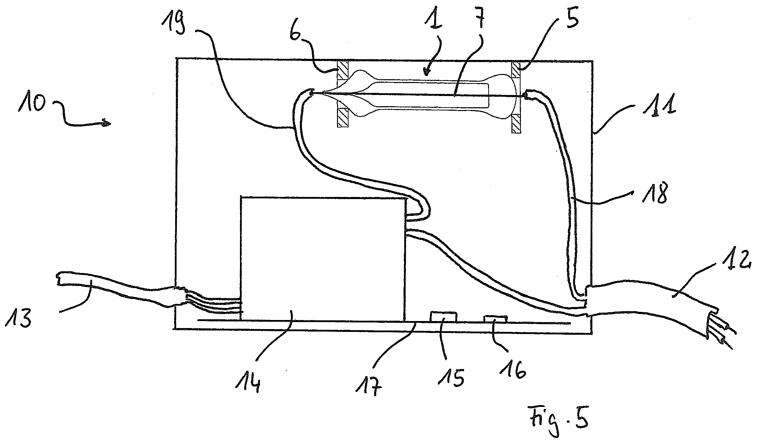

Eine alternative Ausgestaltungsform eines erfindungsgemäßen elektrischen Kleingerätes in Form eines Netzteils 10 ist in Fig. 5 dargestellt. Auch hier ist das Netzteil 10 von einem Gehäuse 11 umschlossen, in welches einerseits das mit der Netzspannung verbundene Netzkabel 12 hinein reicht, aus welchem das Gerätekabel 13 mit der für die Verhältnisse des zu versorgenden elektrischen Gerätes angepassten Gerätespannung abgeht. Ebenfalls sind wieder der Spannungswandler 14 und weitere elektrische Komponenten 15, 16 auf einer Platine 17 angeordnet. Im Unterschied zu dem vorherigen Ausführungsbeispiel sind nicht mehr beide Adern des Versorgungskabels 12 unmittelbar eingangsseitig an den Spannungswandler 14 angeschlossen, vielmehr ist eine Ader 18 hin zu dem Berstgefäß 1, welches hier ein solches gemäß dem Ausführungsbeispiel nach Fig. 2 ist, geführt und dort mit dem in diesem Ausführungsbeispiel ausgebildeten elektrischen Leiter 7 verbunden. Auf der gegenüberliegenden Seite ist an dem elektrischen Leiter 7 eine weitere Ader 19 eines Verbindungskabels angeschlossen, welche dann zum Eingang des Spannungswandlers 14 führt. Diese gegenüber dem Ausführungsbeispiel nach Fig. 4 abweichende Gestalt bewirkt, dass im Falle eines Auslösens des Berstgefäßes 1 der elektrische Leiter 7 reist und mithin die Versorgung des Netzteils 10 mit der an das Netzkabel 12 anliegen Versorgungsspannung unterbrochen ist. Hier wird also zusätzlich zu der Brand verhindernden Wirkung bzw. Löschwirkung der in dem Berstgefäß 1 angeordneten Flüssigkeit auch eine elektrische Unterbrechung nach Art einer Sicherung gewährleistet. Selbstverständlich könnte in dem Ausführungsbeispiel gemäß Fig. 5 das dort wie nach einem Beispiel gemäß Fig. 2 ausgebildete Berstgefäß 1 auch durch ein solches in einer Ausgestaltung nach Fig. 3 ersetzt werden mit gleicher Wirkung.

Zu verstehen ist hierbei insbesondere, dass in den Figuren 4 und 5 die gezeigten Volumenverhältnisse zwischen dem Volumen des Hohlraumes des Berstgefäßes und dem Gesamtvolumen des Gehäuses nicht maßstabsgetreu sind, hier ist das Berstgefäß 1 der besseren Veranschaulichung wegen vergrößert dargestellt. Dabei wird das Fassungsvolumen des Berstgefäßes 1 so ausgelegt werden, dass bei einem Auslösen und Verdampfen der darin befindlichen Flüssigkeit der chemische Stoff der Flüssigkeit, der dann gasförmig vorliegt, das Innenvolumen des Gehäuses 11 sicher ausfüllt.

## Patentansprüche

1. Elektrisches Kleingerät mit einem Gehäuse (11), in welchem elektrische Komponenten (14, 15, 16) angeordnet sind, wobei in dem Gehäuse (11) eine Brandschutzeinrichtung (1) angeordnet ist, **dadurch gekennzeichnet, dass** die Brandschutzeinrichtung (1) aus einem einen vollständig umschlossenen und von einer Gefäßwand begrenzten Hohlraum (2) aufweisenden Berstgefäß (1) in Form eines Glasfässchens, besteht und in dem Hohlraum eine Flüssigkeit angeordnet ist, die
a. aufgrund thermischer Ausdehnung bei einer vorbestimmten Auslösetemperatur die Gefäßwand brechen und das Glasfässchen (1) bersten lässt;
b. eine, durch Verdrängung oder Bindung von für jegliche Form eines Brandes erforderlichen Sauerstoffes aus dem Gehäuse (11) des elektrischen Kleingerätes und/oder durch homogene Inhibition und/oder durch Schaumbildung, Brand verhindernde Wirkung und/oder Löschwirkung hat.

2. Elektrisches Kleingerät nach Anspruch 1, **dadurch gekennzeichnet, dass** in dem Hohlraum (2) des Glasfässchens (1) zusätzlich zu der Flüssigkeit eine Gasblase angeordnet ist.

3. Elektrisches Kleingerät nach einem der vorhergehenden Ansprüche, **dadurch gekennzeichnet, dass** die Flüssigkeit in dem Hohlraum (2) des Glasfässchens (1) einen Siedepunkt bei einer Temperatur unterhalb der vorbestimmten Auslösetemperatur aufweist.

4. Elektrisches Kleingerät nach einem der vorhergehenden Ansprüche, **dadurch gekennzeichnet, dass** die Flüssigkeit in dem Hohlraum (2) des Glasfässchens (1) ein Halon ist.

5. Elektrisches Kleingerät nach einem der vorhergehenden Ansprüche, **dadurch gekennzeichnet, dass** die Flüssigkeit in dem Hohlraum (2) des Glasfässchens (1) ein fluoriertes Keton ist, insbesondere ein perfluoriertes Ethyl-Isopropylketon.

6. Elektrisches Kleingerät nach einem der vorhergehenden Ansprüche, **gekennzeichnet durch** einen zwischen zwei auf dem Glasfässchen (1) ausgebildeten Kontaktpunkten geführten elektrischen Leiter (7; 8), der so ausgebildet ist, dass er bei einem Bersten des Glasfässchens (1) zerstört wird.

7. Elektrisches Kleingerät nach Anspruch 6, **dadurch gekennzeichnet, dass** eine elektrische Versorgungsleitung (12) des elektrischen Kleingerätes (10) mit den Kontaktpunkten auf dem Glasfässchen (1) verbunden und über den zwischen diesen Kontaktpunkten geführten Leiter (7) gelegt ist.

8. Verwendung eines einen vollständig umschlossenen und von einer Gefäßwand begrenzten Hohlraum (2) aufweisenden Berstgefäßes (1) in Form eines Glasfässchens (1), bei dem in dem Hohlraum (2) eine Flüssigkeit angeordnet ist, die
a) aufgrund thermischer Ausdehnung bei einer vorbestimmten Auslösetemperatur die Gefäßwand brechen und das Glasfässchen (1) bersten lässt und
b) eine, durch Verdrängung oder Bindung von für jegliche Form eines Brandes erforderlichen Sauerstoffes aus dem Gehäuse (11) des elektrischen Kleingerätes und/oder durch homogene Inhibition und/oder durch Schaumbildung, Brand verhindernde Wirkung und/oder eine Löschwirkung hat,
als Brandschutzeinrichtung für ein elektrisches Kleingerät (10) durch Anordnung in einem Gehäuse (11) eines solchen elektrischen Kleingerätes (10).

9. Verwendung nach Anspruch 8, **dadurch gekennzeichnet, dass** in dem Hohlraum (2) des Glasfässchens (1) zusätzlich zu der Flüssigkeit eine Gasblase angeordnet ist.

10. Verwendung nach einem der Ansprüche 8 oder 9, **dadurch gekennzeichnet, dass** die Flüssigkeit in dem Hohlraum (2) des Glasfässchens (1) einen Siedepunkt bei einer Temperatur unterhalb der vorbestimmten Auslösetemperatur aufweist.

11. Verwendung nach einem der Ansprüche 8 bis 10, **dadurch gekennzeichnet, dass** die Flüssigkeit in dem Hohlraum (2) des Glasfässchens (1) ein Halon ist.

12. Verwendung nach einem der Ansprüche 8 bis 11, **dadurch gekennzeichnet, dass** die Flüssigkeit in dem Hohlraum (2) des Glasfässchens (1) ein fluoriertes Keton ist, insbesondere ein perfluoriertes Ethyl-Isopropylketon.

13. Verwendung nach einem der Ansprüche 8 bis 12, **dadurch gekennzeichnet, dass** ein elektrischer Leiter (7; 8), der durch einen zwischen zwei auf dem Glasfässchen (1) ausgebildeten Kontaktpunkten geführt wird, so ausgebildet ist, dass er bei einem Bersten des Glasfässchens (1) zerstört wird.

14. Verwendung nach dem Anspruch 13, **dadurch gekennzeichnet, dass** eine elektrische Versorgungsleitung (12) des elektrischen Kleingerätes (10) mit den Kontaktpunkten auf dem Glasfässchen (1) verbunden und über den zwischen diesen Kontaktpunkten geführten Leiter (7) gelegt ist.

## Claims

1. A small electrical device with a housing (11) in which electrical components (14, 15, 16) are arranged, wherein a fire protection device (1) is arranged in the housing (11), **characterized in that**
the fire protection device (1) consists of an explosive containment vessel (1) in the form of a glass vial having a cavity (2) completely enclosed and bounded by a vessel wall, and **in that** a liquid is provided in the cavity, which
a. due to thermal expansion and at a predetermined release temperature, breaks the vessel wall and causes the explosition of the glass keg (1);
b. has a fire-preventing effect and/or extinguishing effect, by displacement or binding of oxygen required for any form of fire, from the housing (11) of the electrical appliance and/or by homogeneous inhibition and/or by foaming,

2. The small electrical device according to claim 1, **characterised in that** a gas bubble is provided in the cavity (2) of the glass keg (1) in addition to the liquid.

3. The small electrical device according to one of the preceding claims, **characterised in that** the liquid has a boiling point at a temperature below the predetermined release temperature, in the cavity (2) of the glass keg (1).

4. The small electrical device according to one of the preceding claims, **characterised in that** the liquid in the cavity (2) of the glass keg (1) is a halon.

5. The small electrical device according to one of the preceding claims, **characterised in that** the liquid in the cavity (2) of the glass keg (1) is a fluorinated ketone, in particular a perfluorinated ethyl isopropyl ketone.

6. The small electrical device according to one of the preceding claims, **characterised by** an electrical conductor (7; 8) guided between two contact points formed on the glass keg (1), designed in such a way that it is destroyed when the glass keg (1) bursts.

7. The small electrical device according to claim 6, **characterised in that** an electrical supply line (12) of the small electrical device (10) is connected with the contact points on the glass keg (1) and placed over the conductor (7) guided between these contact points.

8. The use of an explosive containment vessel (1) in the form of a glass keg (1), having a cavity (2) completely enclosed and bounded by a vessel wall, and in that a liquid is provided in the cavity (2), which
a) due to thermal expansion and at a predetermined release temperature, breaks the vessel wall and causes the explosition of the glass keg (1) and
b) has a fire-preventing effect and/or extinguishing effect, by displacement or binding of oxygen required for any form of fire, from the housing (11) of the electrical appliance and/or by homogeneous inhibition and/or by foaming, as a fire protection device for a small electrical device (10) by arrangement in a housing (11) of such a small electrical device (10).

9. The use of Claim 8, **characterised in that** a gas bubble is provided in the cavity (2) of the glass keg (1) in addition to the liquid.

10. The use according to one of claims 8 or 9, **characterised in that** the liquid has a boiling point at a temperature below the predetermined release temperature, in the cavity (2) of the glass keg (1).

11. The use according to one of the claims 8 to 10, **characterised in that** the liquid in the cavity (2) of the glass keg (1) is a halon.

12. The use according to one of claims 8 to 11, **characterised in that** the liquid in the cavity (2) of the glass keg (1) is a fluorinated ketone, in particular a perfluorinated ethyl isopropyl ketone.

13. The use according to one of claims 8 to 12, characterised that an electrical conductor (7;8), guided between two contact points formed on the glass keg (1), is designed in such a way that it is destroyed when the glass keg (1) bursts.

14. The use according to claim 13, **characterised in that** an electrical supply line (12) of the small electrical device (10) is connected with the contact points on the glass keg (1) and placed over the conductor (7) guided between these contact points.

## Revendications

1. Petit appareil électrique avec un boîtier (11) dans lequel sont disposés des composants électriques (14, 15, 16), dans lequel un dispositif de protection anti-incendie (1) est disposé dans le boîtier (11), **caractérisé en ce que** le dispositif de protection anti-incendie (1) est constitué d'un récipient de confinement explosif (1) sous la forme d'un flacon en verre ayant une cavité (2) complètement fermée et délimitée par une paroi de récipient, et **en ce qu'**un liquide est prévu dans la cavité, lequel
a. en raison de la dilatation thermique et à une température de déclenche-ment prédéterminée, brise la paroi du récipient et provoque l'explosion du flacon de verre (1);
b. a un effet de prévention et/ou d'extinction des incendies, par déplacement ou liaison d'oxygène requis pour toute forme d'incendie, à partir du logement (11) de l'appareil électrique et/ou par inhibition homogène et/ou par formation de mousse.

2. Petit appareil électrique selon la revendication 1, **caractérisé en ce qu'**une bulle de gaz est prévue dans la cavité (2) du flacon de verre (1) en plus du liquide.

3. Petit appareil électrique selon l'une des revendications précédentes, **caractérisé en ce que** le liquide présente un point d'ébullition à une température inférieure à la température de déclenchement prédéterminée, dans la cavité (2) du flacon de verre (1).

4. Petit appareil électrique selon l'une des revendications précédentes, **caractérisé en ce que** le liquide dans la cavité (2) du flacon de verre (1) est un halon.

5. Petit appareil électrique selon l'une des revendications précédentes, **caractérisé en ce que** le liquide dans la cavité (2) du flacon de verre (1) est une cétone fluorée, en particulier une éthyle isopropyle cétone perfluorée.

6. Petit appareil électrique selon l'une des revendications précédentes, **caractérisé par** un conducteur électrique (7; 8), guidé entre deux points de contact formés sur le flacon de verre (1), conçu de telle manière qu'il est détruit lorsque le flacon de verre (1) éclate.

7. Petit appareil électrique selon la revendication 6, **caractérisé en ce qu'**une ligne d'alimentation électrique (12) du petit appareil électrique (10) est connectée aux points de contact sur le flacon de verre (1) et placée sur le conducteur (7) guidé entre ces points de contact.

8. Utilisation d'un récipient de confinement explosif (1) sous forme d'un flacon de verre (1), présentant une cavité (2) complètement fermée et délimitée par une paroi de récipient, et en ce qu'un liquide est prévu dans la cavité (2), qui
a) en raison de la dilatation thermique et à une température de déclen-chement prédéterminée, brise la paroi du récipient et provoque l'explosion du flacon de verre (1) et
b) a un effet de prévention et/ou d'extinction des incendies, par déplacement ou liaison d'oxygène requis pour toute forme d'incendie, à partir du logement (11) de l'appareil électrique et/ou par inhibition homogène et/ou par formation de mousse, en tant qu'appareil de protection anti-incendie pour un petit appareil électrique (10) par agencement dans un logement (11) d'un tel petit appareil électrique (10).

9. Utilisation selon la revendication 8, **caractérisé en ce qu'**une bulle de gaz est prévue dans la cavité (2) du flacon de verre (1) en plus du liquide.

10. Utilisation selon l'une quelconque des revendications 8 ou 9, **caractérisé en ce que** le liquide présente un point d'ébullition à une température inférieure à la température de déclenchement, dans la cavité (2) du flacon de verre (1).

11. Utilisation selon l'une des revendications 8 à 10, **caractérisé en ce que** le liquide dans la cavité (2) du flacon de verre (1) est un halon.

12. Utilisation selon l'une des revendications 8 à 11, **caractérisé en ce que** le liquide dans la cavité (2) du flacon de verre (1) est une cétone fluorée, en particulier une éthyle isopropyle cétone perfluorée.

13. Utilisation selon l'une des revendications 8 à 12, **caractérisé par** un conducteur électrique (7; 8), guidé entre deux points de contact formés sur le flacon de verre (1), conçu de telle manière qu'il est détruit lorsque le flacon de verre (1) éclate.

14. Utilisation selon la revendication 13, **caractérisé en ce qu'**une ligne d'alimentation électrique (12) du petit appareil électrique (10) est connectée aux points de contact sur le flacon de verre (1) et placée sur le conducteur (7) guidé entre ces points de contact.
